# EUROPEAN PATENT SPECIFICATION

(11) **EP 1 300 507 B1**
(45) Date of publication and mention of the grant of the patent: **08.02.2006**
(21) Application number: 02256431.4
(22) Date of filing: 13.09.2002
(51) Int. Cl.: D06M 15/55, B29C 70/06, B29C 70/50, B29B 15/12

(54) **Fibre reinforced resin assembly**
Faserverstärkte Kunststoffe
Résine renforcée par des fibres

(30) Priority: 14.09.2001 GB 0122195; 13.06.2002 GB 0213523
(43) Date of publication of application: 09.04.2003
(73) Proprietor: Hexcel Composites Limited, Cambridge CB2 4QD (GB)
(72) Inventor: Simmons, Martin Richard, Cambridge, CB1 3HR (GB); Cawse, John Leslie, Cambridge, CB1 5NH (GB); Ellis, John, Cambridge, CB2 2SF (GB)
(74) Representative: Wilson Gunn

(56) References cited:
- EP-A- 0 604 909
- FR-A- 1 544 582
- FR-A- 2 537 921
- US-A- 2 854 031
- US-A- 3 062 697
- US-A- 4 076 869
- US-A- 4 339 571
- US-A- 4 992 228
- US-A- 5 176 949
- DATABASE WPI Section Ch, Week 199402 Derwent Publications Ltd., London, GB; Class A21, AN 1994-011627 XP002266261 & JP 05 318482 A (SUMITOMO BAKELITE CO), 3 December 1993 (1993-12-03)
- DATABASE WPI Section Ch, Week 199418 Derwent Publications Ltd., London, GB; Class A31, AN 1994-147320 XP002266262 & JP 06 091638 A (RISHO IND CO LTD), 5 April 1994 (1994-04-05)

## Description

The present invention relates to a fibre reinforced resin assembly.

Fibre reinforced resin assemblies are widely used as structural components, in industrial and leisure applications, in aerospace and for electronic circuit board applications. These assemblies are generally supplied as a prepreg. However, these assemblies may also be supplied as semi-pregs, adhesives and as components of resin film infusion materials. Prepreg materials comprise a fibrous reinforcement phase together with a matrix resin comprising one or more liquid resins, one or more curing agents and optionally other additives such as tougheners, flame retardants, fillers and the like forming together a so-called matrix resin. The matrix resin can generally be cured at temperatures in the range from 50°C to 200°C.

Known prepregs have limited preservation stability in their uncured state at room temperature. This is particularly evident in low-temperature cure matrix resin compositions. For example, a matrix resin composition consisting of an epoxy resin and an imidazole curing agent, that can be cured at 60°C, can have a room temperature stability of less than two days rendering it unusable thereafter. Stability during storage at room temperature is important, especially if materials are to be transported long distances, and/or stored at ambient temperatures before use. It is, of course, possible to store these known prepregs at temperatures below room temperature to enhance their shelf life, but the need for large or expensive refrigeration units can make this option undesirable.

Additionally it is essential that the matrix resin does not flow during storage or lay-up. This may be achieved by formulating a matrix resin in which solid epoxy resins have high molecular weights or are highly viscous.

It is also desirable for at least one side of the assembly to have a certain degree of tack. This is required during the lay up of assemblies. If the assembly has no tack it can prove difficult to assemble together different layers of assembly in the mould.

It is, furthermore, desirable that the assembly has a certain degree of flexibility to enable it to be formed into the desired shape. This is also required if the assembly is to be supplied in rolls.

It is well known that epoxy resins may crystallise at room temperature but this is commonly regarded as a disadvantage and even a nuisance, because the crystallisation can interfere with the mixing and other operations used in the manufacture of conventional assemblies.

According to a first aspect of the present invention there is provided a fibre reinforced resin assembly comprising a fibrous web and a matrix resin composition comprising a crystalline epoxy resin and a crystalline epoxy resin curing agent, wherein the said epoxy resin curing agent is substantially uniformly dispersed in the crystalline epoxy resin.

The matrix resin composition may be applied to the fibrous web in such a way as to either fully or partially impregnate the fibres. Alternatively, the said resin composition may be in the form of a separate layer which is in contact with the fibres but does not impregnate the fibres.

In a still further alternative the matrix resin composition may be such that it has adhesive properties.

When in the form of an adhesive, the matrix resin composition is preferably in the form of a film. With this arrangement the assembly may optionally comprise a light scrim or carrier cloth.

The assemblies of the invention have excellent room temperature stability, typically of 3 to 6 months, thus providing increased room temperature outlife. Furthermore they may be cured at a conveniently low temperature in the range from 50°C to 200°C, and preferably at temperatures lower than 100°C, and most preferably in the temperature range 50 °C to 70°C so as to provide a rigid laminate. The use of crystalline epoxy resin has no effect on the mechanical properties of the laminate compared with a non-crystalline epoxy resin.

The fibrous web may comprise an organic or inorganic fibre either alone or in combination for example carbon:- glass, aramid, polyethylene, ceramic, natural fibres such as kenaf, hemp and cellulose. The fibres may be utilized in unidirectional form, or as non-wovens, such as multi-axial fabrics or non-crimped fabrics, or may be present as a woven fabric or non-woven mat or fabric or combinations thereof.

The matrix resin composition of the present invention may be loaded onto the fibrous web in quantities in the range from 30gm⁻² to 3000gm⁻².

The epoxy resin must be crystalline. Preferred epoxy resins include diglycidyl ethers of bisphenol A and bisphenol F and their halogenated derivatives and can be represented by the general formula: 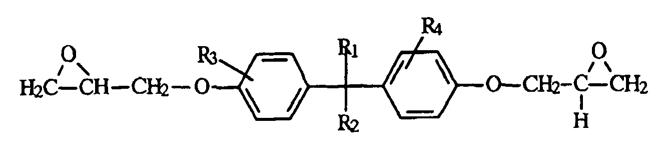
where
R¹ is hydrogen, halogen or a hydrocarbon group with one to six carbon atoms or may with R² form part of a ring;
R² is hydrogen, halogen or a hydrocarbon group with one to six carbon atoms or may with R¹ form part of a ring;
R³ is hydrogen, halogen or a hydrocarbon group with one to six carbon atoms; and
R⁴ is hydrogen, halogen or a hydrocarbon group with one to six carbon atoms.

The aforementioned resins can be used alone or as a mixture with other crystallisable or solid crystallisable resins also of the aforementioned kind.

The melting point of these epoxy resins is preferably in the range from 35°C to 50°C.

DER 332 as supplied by Dow Chemical is a pure form of a diglycidyl ether of bisphenol A that is suitable for this invention. Rutapox 0158 as supplied by Bakelite is a diglycidyl ether of bisphenol F that is also suitable for the invention. Although supplied as liquids these resins can crystallise.

The epoxy curing agents must be crystalline. Preferred curing agents include any compounds that give latent thermal cure of at least five to seven days. Such compounds are well known to those skilled in the art. Suitable examples include imidazoles and their salts and adducts. These epoxy curing agents are solid at room temperature. Preferred examples of suitable curing agents are disclosed in EP 906927A. Other preferred curing agents include aromatic amines, aliphatic amines, anhydrides and phenols. The composition of the present invention may additionally comprise insoluble thermoplastic toughening particles, resin soluble thermoplastic toughening agents which precipitate upon curing, release agents to facilitate release from mould and flame retardants which may be intumescent and other modifiers well known to those in the art.

The matrix resin composition of the invention preferably contains a flexibilising agent. The flexibilising agent is selected so as to have substantially no effect on outlife or the ability of the major epoxy component to be present as a crystalline solid. Liquid rubbers, epoxy novolacs, acrylate monomers, methacrylate monomers and vinyl esters, are also suitable as additives for flexibilising the composition. These can be added as a minor component of the composition so as not to prevent the crystallisation of the major epoxy resin component.

An example of a liquid rubber that is suitable as a flexibilising agent is HYCAR 1300 X18 (trade mark) as supplied by BF Goodrich.

An example of a vinyl ester resin that is suitable as a flexibilising agent is Actilane 320, supplied by Akzo Nobel.

The flexibilising agent is preferably present in an amount from 1% to 10% by weight of the composition.

It is preferable that the flexibilising agent is added to the matrix resin composition directly. In product forms where there is a high degree of fibre impregnation, the flexibilising agent may be added to the composition by spraying the liquid agent onto the surface of the impregnated web or applying the agent to release paper and then transferring the agent to the web.

The assemblies of the present invention preferably contain a tackifying agent. The tackifying agent is selected so as to have substantially no effect on outlife or the ability of epoxy resin to be present as a crystalline solid.

The tackifying agent must be non-epoxy. Suitable tackifying agents include pressure sensitive adhesives such as those based on polyurethanes, acrylates, natural rubber and others, and which may be in the form of solutions, aerosols, dispersions or emulsions.

The tackifying agent is applied to at least one outer face of the fibre reinforced assembly of the present invention by spraying the liquid agent onto the surface of the assembly or applying the agent to release paper and then transferring the agent to the assembly or by a printing technique or by any other suitable means.

The matrix resin compositions of the invention may additionally comprise one or more inorganic fillers. Preferred fillers include silica, alumina, aluminium powder, titanium dioxide, aluminium hydroxide and talc.

Further minor ingredients may be included in the matrix resin composition such as any of the following:- accelerators, thermoplastics and core shell rubbers, flame retardants which may be intumescent, wetting agents, pigments/dyes, UV absorbers, toughening particles and viscosity modifiers.

The assembly of the present invention may also include electrically conductive mesh for dissipating lightening strikes.

The assembly of the present invention may be coated with a surface finishing film on at least one face.

The matrix resin composition of the present invention may additionally comprise insoluble thermoplastic toughening particles, resin soluble thermoplastic toughening agents which precipitate upon curing, release agents to facilitate release from a mould and flame retardants which may be intumescent.

According to a second aspect of the present invention there is provided a process for making a fibre reinforced resin assembly comprising substantially uniformly mixing a crystalline epoxy resin curing agent with a crystalline epoxy resin to form a matrix resin , melting the matrix resin, applying the matrix resin to a fibrous web and recrystallising the molten matrix resin composition.

Any process for producing the matrix resin of the invention may be used as long as the epoxy curing agent is uniformly dispersed within a crystalline epoxy resin. The method can be carried out in the molten state, solid state or by mixing the components in a solvent. This mixing is preferably carried out at room temperature. If the temperature exceeds 50°C the epoxy curing agent may initiate polymerisation of the epoxy resin. The matrix resin composition is then applied to a fibrous web to form an assembly as referred to herein. Preferably this process will occur at or close to room temperature. If too high a temperature is used the resin composition may start to cure affecting recrystallisation of the epoxy resin and ultimately the room temperature storage stability. If the material was impregnated with molten material it is cooled to a temperature lower than the melting point of the epoxy and preferably at a temperature lower than 10°C. This process will aid recrystallisation.

Preferred methods of forming the fibre reinforced assemblies of the invention are now described with reference to the accompanying drawings in which:-
Fig. 1 is a schematic diagram showing one process for making assemblies comprising a fibrous web and a matrix resin composition in accordance with the invention;
Fig. 2 is a schematic diagram showing a second process for making assemblies comprising a fibrous web and a matrix resin composition in accordance with the invention; and
Fig. 3 is a schematic diagram showing a third process for making assemblies comprising a fibrous web and a matrix resin composition in accordance with the invention.

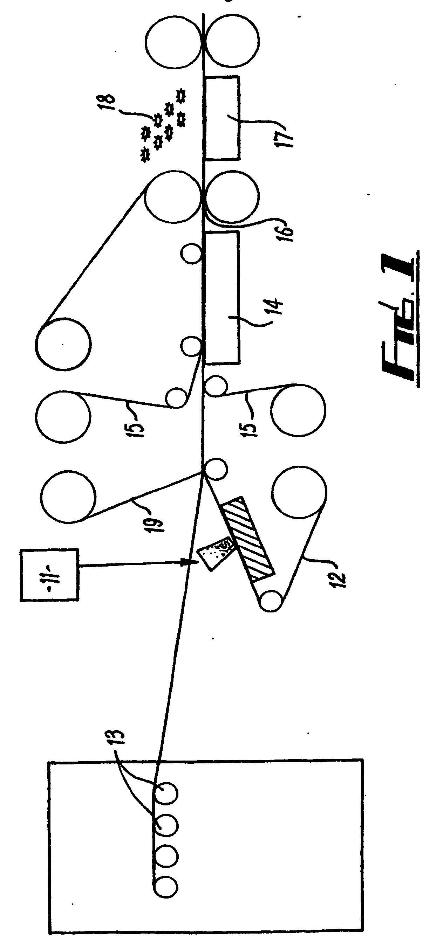

The fibrous web may be synthetic or natural fibres, such as carbon, glass, aramid, hemp, kenaf, or any other form of material or combination of materials that, combined with the matrix resin composition of the invention, forms a composite product In figures 1,2 and 3 the fibrous web can either be provided via spools of fibre which are unwound or from a roll of textile.

Referring to Fig. 1 a crystalline epoxy resin is heated to a temperature above its melting point and is then allowed to cool to room temperature. A crystalline epoxy curing agent is then uniformly mixed with the liquid resin and a flexibilising agent to provide a mixture which is fed via feeder 11 onto the moving web 12, which may be release paper, release paper coated with a tackifying film, or textile. If required, fibre from spools 13 or a textile 19 or both may be added to the web as reinforcement materials. A mixture 15 of epoxy resin and tackifier may be added via lamination of a pre-coated film to either or both sides the main web if required. The web and resin pass over a heated table 14 with pressure rolls into a heated compaction nip 16 to achieve the required degree of impregnation. Heat is applied at a temperature which is lower than the melting point of the epoxy curing agent, but equal to or higher than the melting point of the epoxy resin. The now impregnated web, is then cooled by a refrigeration unit 17 to a temperature lower than the melting point of the epoxy resin but preferably to a temperature lower than 10°C to allow the epoxy resin to recrystallise. The recrystallisation can be accelerated if required by adding epoxy resin crystals 18 as a nucleating agent. The assembly is then stored at a temperature, preferably -5°C to +10°C, for 2 days to complete the crystallisation process. Once the epoxy resin is fully crystallised the assembly can be stored at room temperature or below the melting point of the epoxy resin.

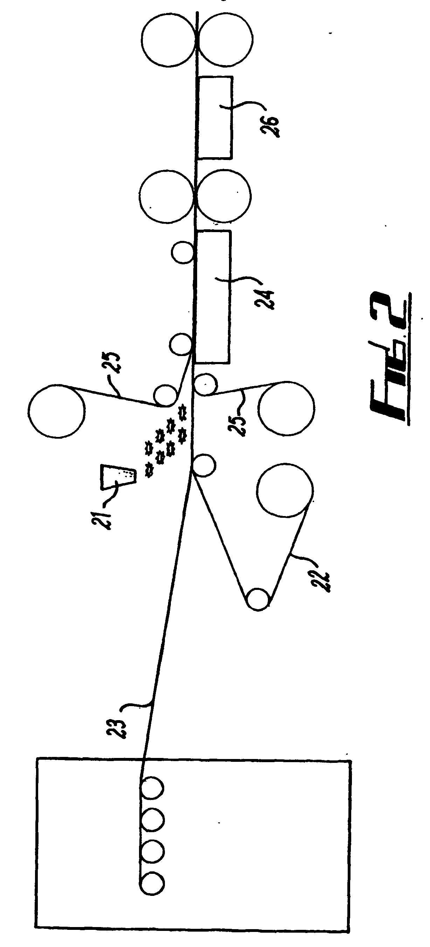

Referring to Fig. 2 a further process for making an assembly in accordance with the invention is shown in which a crystalline epoxy resin is ground together with a crystalline epoxy curing agent so as to provide an intimate mixture 21. This mixture is then fed, with a predetermined loading, onto the web 22 or 23. The web is then fed through a heater 24 via which heat is applied at a temperature which is lower than the melting point of the epoxy curing agent, but equal to or higher than the melting point of the epoxy resin. A mixture 25 of epoxy resin and tackifier may be added via lamination of a pre-coated film to either or both sides the main web if required. The mixture of epoxy resin and epoxy curing agent will now flow sufficiently for it to fully impregnate the reinforcement. The impregnated web is then cooled by a refrigeration unit 26 to a temperature lower than the melting point of the epoxy resin but preferably to a temperature lower than 10°C to allow the epoxy resin to recrystallise. The assembly is then stored at a temperature, preferably -5°C to +10°C, for 2 days to complete the crystallisation process. Once the epoxy resin is fully crystallised the assembly can be stored at room temperature or below the melting point of the epoxy resin.

Another process for producing a fibre reinforced resin assembly entails spraying a mixture of the powdered crystalline epoxy resin and the powdered epoxy curing agent directly onto the reinforcement. This is then a useable crystalline prepreg. Such techniques include electrostatic and fluidised bed technologies and are well known to those skilled in the art.

A still further process for producing a fibre reinforced resin assembly entails preparing a dispersion of the powdered crystalline epoxy resin and the powdered epoxy curing agent in a solvent, applying the dispersion to the fibre and removing the solvent by way of an oven. Such methods are well known to those skilled in the art.

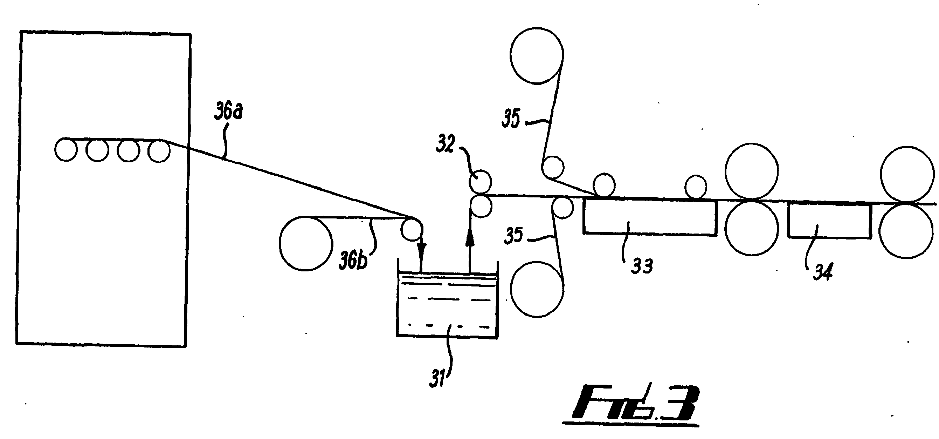

Referring to Fig. 3 a further process for making assemblies in accordance with the invention is shown. A crystalline epoxy resin is heated to a temperature above its melting point and is then allowed to cool to room temperature. A crystalline epoxy curing agent is then uniformly mixed with the liquid resin and a flexibilising agent to provide a mixture which is held in a bath 31. The reinforcement web, 36a or 36b, is immersed in the bath 31 to wet the web. Excess resin is then removed by metering rolls 32 to achieve the required resin content. The web can then be fed, if required to achieve full impregnation, through a heater and compaction rolls 33 via which heat is applied at a temperature which is lower than the melting point of the epoxy curing agent, but equal to or higher than the melting point of the epoxy resin. A mixture 35 of epoxy resin and tackifier may be added via lamination of a pre-coated film to either or both sides of the main web if required. The impregnated web is then cooled by a refrigeration unit 34 to a temperature lower than the melting point of the epoxy resin but preferably to a temperature lower than 10°C to allow the epoxy resin to recrystallise. The prepreg is then stored at a temperature, preferably -5°C to +10°C, for 2 days to complete the crystallisation process. Once the epoxy resin is fully crystallised the assembly can be stored at room temperature or below the melting point of the epoxy resin. The liquid resin dip process can be achieved using a wide range of equipment well known to those skilled in the art.

It is noted that in all the processes described above the tackifier can be applied by spraying onto the assembly online or it can be applied via release paper.

In order that the present invention may be more readily understood specific examples thereof are provided hereinbelow:-

### Example 1

10 grams of DER 332 as supplied by Dow Chemical, a diglycidyl ether of bisphenol A, which can exist as a liquid resin or a crystalline solid was warmed to 45°C to ensure that no crystallinity was present. The resin was allowed to cool to room temperature. 1-(1-Imidazolyl)-2-hydroxyoctadecane, the epoxy curing agent, (hereinafter referred to as curing Agent I) was added to the epoxy resin and mixed uniformly using a stirring rod. The mixture was then allowed to recrystallise at a temperature of 5°C for two days. Crystals of the DER 332 can be added to the mixture to nucleate the crystallisation process. The matrix resin was then allowed to warm to room temperature. On reaching this temperature it was observed that a solid composition was isolated. Differential scanning calorimetry (DSC) was used as a method to detect the melting point of the epoxy resin and the epoxy resin curing agent. The melting points can then be compared with separate DSC traces of the pure components of the composition. DSC was also used to check the outlife of the composition over 6 months. The room temperature shelf life of the crystalline composition is at least four months.

Results are shown in Table 1.

| Sample | Mpt peak 1 (°C) | Mpt peak 2 (°C) |
|---|---|---|
| **DER** 332 | 42.1 | - |
| Curing Agent I | 73.8 | - |
| DER 332 + Curing Agent I | 42.6 | 73.7 |

The melting point peaks in the epoxy resin composition correspond to the melting point peaks of the individual pure components.

### Comparative Example 1

To ten grams of LY1556 as supplied by Vantico a diglycidyl ether of bisphenol A, which is a non-crystallisable liquid resin, was added one gram of Curing Agent I. This composition was uniformly mixed using a stirring rod. The mixture was left for 2 days at 5°C. The mixture was warmed to room temperature. The mixture was still in the liquid form, the DSC trace only showed the melting point peak of the epoxy curing agent. The room temperature shelf life of this composition was determined to be five weeks.

### Example 2

10 grams of Rutapox 0158 as supplied by Bakelite, a diglycidyl ether of bisphenol F, which can exist as a liquid resin or a crystalline solid was warmed to 45°C to ensure that no crystallinity was present. The resin was allowed to cool to room temperature. Epoxy Curing Agent I, was added to the epoxy resin and mixed uniformly using a stirring rod. The mixture was then allowed to recrystallise at a temperature of 5°C for one day. The epoxy composition was then allowed to warm to room temperature. On reaching this temperature it was observed that a solid composition was isolated. Differential scanning calorimetry (DSC) was used to detect the melting point of the epoxy resin and the epoxy resin curing agent. The melting points can then be compared with separate DSC traces of the pure components of the composition. DSC was also used to check the outlife of the composition over 6 months. The room temperature shelf life of the crystalline composition is at least four months.

Results are shown in Table 2.

| Sample | Mpt peak 1 (°C) | Mpt peak 2 (°C) |
|---|---|---|
| Rutapox 0158 | 41.5 | - |
| Curing Agent I | 73.8 | - |
| Rutapox 0158 + Curing Agent I | 73.4 | 41.4 |

The melting point peaks in the epoxy resin composition correspond to the melting point peaks of the individual pure components.

### Comparative Example 2

To ten grams of GY281 as supplied by Vantico, a diglycidyl ether ofbisphenol F, which is a non-crystallisable liquid resin at room temperature, was added one gram of epoxy Curing Agent I. This composition was uniformly mixed using a stirring rod. The mixture was left for 2 days at 5°C. The mixture was warmed to room temperature. The mixture was still in the liquid form, the DSC trace only showed the melting point peak of the epoxy curing agent. The room temperature shelf life of this composition was determined to be five weeks.

### Example 3

One kilogram of DER 332 was warmed to 45°C to ensure no crystalline solid was present. The mixture was allowed to cool to room temperature. One hundred grams Curing Agent I was added and blended thoroughly using a planetary mixer. The epoxy composition was then impregnated on carbon fabric at a resin weight of 35 to 40 wt % using a prepreg machine. The impregnated fabric was passed over a 5°C cooling plate to initiate crystallisation. The epoxy prepreg was covered with a polyethylene wrap and rolled up. The prepreg was immediately stored at 5-10°C for two days to ensure complete recrystallisation. DSC showed melting point peaks for both DER 332 and Curing Agent I. The epoxy prepreg composition had a room temperature storage life of six months.

### Example 4

To one hundred grams of crystalline Rutapox 0158 was added ten grams of Curing Agent I. This mixture was ground together using a pestle and mortar. This mixture was spread evenly over a 200 gm⁻² weight carbon fabric and warmed to 45°C to melt the crystalline Rutapox 0158. The resin content of the prepreg was between 35-40 wt %. Using a K-bar the resin mixture was impregnated into the carbon fabric. The prepreg was cooled to below 10°C to allow recrystallisation of the epoxy resin. The assembly has a storage life greater than six months at room temperature.

### Example 5

A powdered mixture of one hundred grams crystalline Rutapox 0158 and ten grams of Curing Agent I was sprayed on carbon fabric. The resin content of the assembly was between 35 to 40 wt %. The assembly has a storage life greater than six months.

It is to be understood that the above described examples are by way of illustration only. Many modifications and variations are possible.

### Example 6

A crystalline prepreg was prepared as in example 3. The prepreg was allowed to warm to room temperature. A tackifying layer was added to the prepreg by spraying a water-based contact adhesive (3M Fastbond 30) to both sides of the prepreg. The prepreg was stored between polyethylene wrap at room temperature for 28 days and its tack monitored. The tack was sufficient to allow prepreg plies to adhere to each other at room temperature. This tack was maintained throughout the 28 days room temperature storage period.

### Example 7

One hundred grams of Rutapox 0158 as supplied by Bakelite, a diglycidyl ether of bisphenol F, which can exist as a liquid resin or a crystalline solid was warmed to 45°C to ensure that no crystallinity was present. Ten grams of epoxy Curing Agent I was added to the epoxy resin and mixed uniformly using a stirring rod. Five grams of Hycar 1300x18, a liquid rubber as supplied by BF Goodrich was added to the mixture and was mixed uniformly using a stirring rod. The epoxy composition was then impregnated on carbon fabric at a resin weight of 35-40 weight percent using a K-bar. The prepreg was stored between silicone coated release paper at 5-10 °C to ensure complete recrystallisation. The prepreg was then allowed to warm to room temperature and was shown to be flexible since little or none of the epoxy resin flaked off the fabric.

## Claims

1. A fibre reinforced resin assembly comprising a fibrous web and a matrix resin composition comprising a crystalline epoxy resin and a crystalline epoxy resin curing agent, wherein the said epoxy resin curing agent is substantially uniformly dispersed in the crystalline epoxy resin **characterised in that** said epoxy resin is selected from diglycidyl ethers of bisphenol A and bisphenol F and their halogenated derivatives as represented by the general formula: 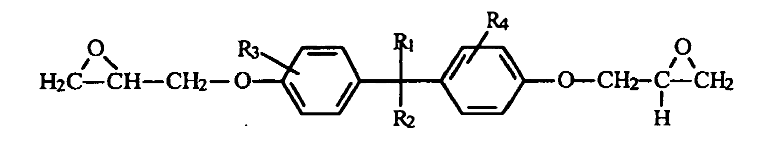
where
R¹ is hydrogen, halogen or a hydrocarbon group with one to six carbon atoms or may with R² form part of a ring;
R² is hydrogen, halogen or a hydrocarbon group with one to six carbon atoms or may with R¹ form part of a ring;
R³ is hydrogen, halogen or a hydrocarbon group with one to six carbon atoms; and
R⁴ is hydrogen, halogen or a hydrocarbon group with one to six carbon atoms.

2. An assembly according to claim 1, wherein the fibrous web is at least partially impregnated by the matrix resin composition.

3. An assembly according to claim 1, wherein the matrix resin composition forms a layer which is in contact with the fibrous web.

4. An assembly according to claim 1, wherein the matrix resin composition has adhesive properties.

5. An assembly according to any preceding claim, wherein the composition is curable in the temperature range from 50°C to 200°C.

6. An assembly according to claim 5, wherein the composition is curable in the temperature range from 50°C to 70°C.

7. An assembly according to any preceding claim, wherein the fibrous web comprises an organic fibre.

8. An assembly according to any preceding claim, wherein the fibrous web comprises an inorganic fibre.

9. An assembly according to any preceding claim, wherein the fibrous web is provided as unidirectional fibres, non-woven fabric, woven fabric or as any combination thereof.

10. An assembly according to any preceding claim, wherein the matrix resin composition is loaded onto the fibrous web in quantities in the range from 30 to 3000gm⁻².

11. An assembly according to any preceding claim, wherein the epoxy curing agent is selected from any of the following either alone or in combination:- imidazoles and their salts and adducts, aromatic amines, aliphatic amines, anhydrides and phenols.

12. An assembly according to any preceding claim, wherein the composition contains at least one flexibilising agent.

13. An assembly according to claim 12, wherein the flexibilising agent is selected from any of the following either alone or in combination:- liquid rubbers, epoxy novalacs, acrylate monomers, methacrylate monomers and vinyl esters.

14. An assembly according to claim 12 or claim 13, wherein the flexibilising agent constitutes from 1% to 10% by weight of the composition.

15. An assembly according to any preceding claim, wherein the composition comprises at least one non-epoxy tackifying agent.

16. An assembly according to claim 15, wherein the tackifying agent is a pressure sensitive adhesive selected from any of the following either alone or in combination:-polyurethanes, acrylates and natural rubber.

17. An assembly according to any preceding claim, wherein the composition comprises one or more inorganic fillers.

18. An assembly according to claim 17, wherein the inorganic filler is selected from any of the following either alone or in combination:- silica, alumina, aluminium powder, titanium dioxide, aluminium hydroxide and talc.

19. An assembly according to any preceding claim, wherein the composition comprises electrically conductive mesh.

20. A process for making an assembly comprising substantially uniformly mixing a crystalline epoxy resin curing agent with a crystalline epoxy resin to form a matrix resin , said epoxy resin being selected from diglycidyl ethers of bisphenol A and bisphenol F and their halogenated derivatives as represented by the general formula: 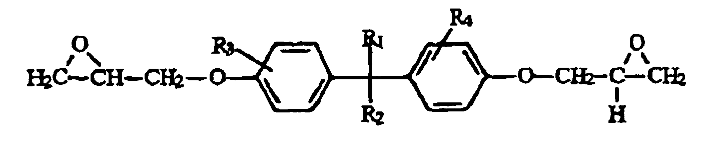 where
R¹ is hydrogen, halogen or a hydrocarbon group with one to six carbon atoms or may with R² form part of a ring;
R² is hydrogen, halogen or a hydrocarbon group with one to six carbon atoms or may with R¹ form part of a ring;
R³ is hydrogen, halogen or a hydrocarbon group with one to six carbon atoms; and
R⁴ is hydrogen, halogen or a hydrocarbon group with one to six carbon atoms, melting the resulting matrix resin, applying the resulting matrix resin to a fibrous web and recrystallising the molten matrix resin composition

## Patentansprüche

1. Faserverstärkter Harzaufbau mit einer fasrigen Bahn und einer Matrix-Zusammensetzung mit einem kristallinen Epoxyharz und einem Härtungsmittel für ein kristallines Epoxyharz, in dem das Epoxyharz-Härtungsmittel praktisch gleichförmig in dem kristallinen Epoxyharz dispergiert ist, **dadurch gekennzeichnet, dass** das Epoxyharz ausgewählt ist aus Diglycidylethern von Bisphenol A und Bisphenol F und ihren halogenierten Derivaten, dargestellt durch die allgemeine Formel: 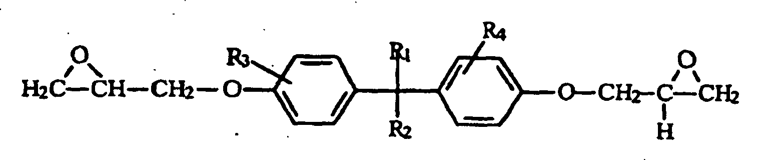
in der
R¹ steht für ein Wasserstoffatom, ein Halogenatom oder eine Kohlenwasserstoffgruppe mit eins bis sechs Kohlenstoffatomen oder R¹ kann mit R² einen Teil eines Ringes bilden;
R² steht für ein Wasserstoffatom, ein Halogenatom oder eine Kohlenwasserstoffgruppe mit eins bis sechs Kohlenstoffatomen oder R² kann mit R¹ einen Teil eines Ringes bilden;
R³ steht für ein. Wasserstoffatom, ein Halogenatom oder eine Kohlenwasserstoffgruppe mit eins bis sechs Kohlenstoffatomen; und
R⁴ steht für ein Wasserstoffatome, ein Halogenatom oder eine Kohlenwasserstoffgruppe mit eins bis sechs Kohlenstoffatomen.

2. Aufbau gemäß Anspruch 1, in dem die fasrige Bahn mindestens teilweise mit der Matrixharz-Zusammensetzung imprägniert ist.

3. Aufbau gemäß Anspruch 1, in dem die Matrixharz-Zusammensetzung eine Schicht bildet, die sich in Kontakt mit der fasrigen Bahn befindet.

4. Aufbau gemäß Anspruch 1, in dem die Matrixharz-Zusammensetzung adhäsive Eigenschaften hat.

5. Aufbau gemäß einem der vorstehenden Ansprüche, in dem die Zusammensetzung in dem Temperaturbereich von 50 °C bis 200 °C härtbar ist.

6. Aufbau gemäß Anspruch 5, in dem die Zusammensetzung in dem Temperaturbereich von 50 °C bis 70 °C härtbar ist.

7. Aufbau gemäß einem der vorstehenden Ansprüche, in dem die fasrige Bahn eine organische Faser enthält.

8. Aufbau gemäß einem der vorstehenden Ansprüche, in dem die fasrige Bahn eine anorganische Faser enthält.

9. Aufbau gemäß einem der vorstehenden Ansprüche, in dem die fasrige Bahn durch in einer Richtung gerichtete Fasern gebildet wird,durch eine Non-Wovenware, durch eine gewebte Ware oder durch eine Kombination hiervon:

10. Aufbau gemäß einem der vorstehenden Ansprüche, in dem die Matrixharz-Zusammensetzung auf die fasrige Bahn in Mengen im Bereich von 30 bis 3000 gm⁻² aufgebracht ist.

11. Aufbau gemäß einem der vorstehenden Ansprüche, in dem das Epoxy-Härtungsmittel ausgewählt ist aus: Imidazolen und ihren Salzen und Addukten, aromatischen Aminen, aliphatische Aminen, Anhydriden und Phenolen, allein oder in Kombination miteinander.

12. Aufbau gemäß einem der vorstehenden Ansprüche, in dem die Zusammensetzung mindestens ein Flexibilisierungsmittel enthält.

13. Aufbau gemäß Anspruch 12, in dem das Flexibilisierungsmittel ausgewählt ist aus: flüssigen Gummis, Epoxy-Novolaken, Acrylatmonomeren, Methacrylatmonomeren und Vinylestern, allein oder in Kombination miteinander.

14. Aufbau gemäß Anspruch 12 oder Anspruch 13, in dem das Flexibilisierungsmittel 1 Gew.-% bis 10 Gew.-% der Zusammensetzung ausmacht.

15. Aufbau gemäß einem der vorstehenden Ansprüche, in dem die Zusammensetzung mindestens ein klebrig machendes Nicht-Epoxymittel aufweist.

16. Aufbau gemäß Anspruch 15, in dem das klebrig machende Mittel ein druckempfindlicher Klebstoff ist, ausgewählt aus Polyurethanen, Acrylaten und natürlichem Gummi, allein oder in Kombination miteinander:

17. Aufbau nach einem der vorstehenden Ansprüche, in dem die Zusammensetzung ein oder mehrere anorganische Füllstoffe enthält.

18. Aufbau gemäß Anspruch 17, in dem der anorganische Füllstoff ausgewählt ist aus Silica, Aluminiumoxid, Aluminiumpulver, Titandioxid, Aluminiumhydroxid und Talkum, allein oder in Kombination miteinander.

19. Aufbau gemäß einem der vorstehenden Ansprüche, in dem die Zusammensetzung ein elektrisch leitfähiges Netzwerk aufweist.

20. Verfahren zur Herstellung eines Aufbaues, das umfasst ein praktisch gleichförmiges Vermischen eines kristallinen Epoxyharz-Härtungsmittels mit einem kristallinen Epoxyharz unter Erzeugung eines Matrixharzes, wobei das Epoxyharz ausgewählt ist aus Diglycidylethern von Bisphenol A und Bisphenol F und ihren halogenierten Derivaten, dargestellt durch die allgemeine Formel: 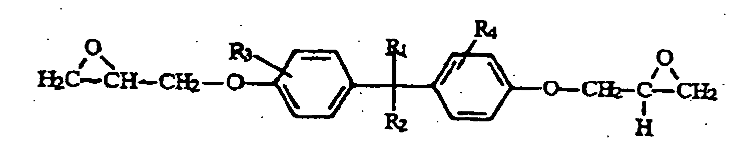
worin
R¹ für ein Wasserstoffatom, ein Halogenatom oder eine Kohlenwasserstoffgruppe mit eins bis sechs Kohlenstoffatomen steht oder mit R² Teil eines Ringes bilden kann;
R² für ein Wasserstoffatom, ein Halogenatom oder eine Kohlenwasserstoffgruppe mit eins bis sechs Kohlenstoffatomen steht oder mit R¹ Teil eines Ringes bilden kann;
R³ für ein Wasserstoffatom, ein Halogenatom oder eine Kohlenwasserstoffgruppe mit eins bis sechs Kohlenstoffatomen steht; und
R⁴ für ein Wasserstoffatom , ein Halogenatom oder eine Kohlenwasserstoffgruppe mit eins bis sechs Kohlenstoffatomen steht, und bei dem das erhaltene Matrixharz aufgeschmolzen wird, das erhaltene Matrixharz auf eine fasrige Bahn aufgebracht wird und bei dem die aufgeschmolzene Matrixharz-Zusammensetzung rekristallisiert wird.

## Revendications

1. Assemblage de résine renforcé par des fibres comprenant une bande fibreuse et une composition de la résine matrice comprenant une résine époxy cristalline et un agent de durcissement de résine époxy cristalline, dans lequel ledit agent de durcissement de résine époxy cristalline est pour l'essentiel uniformément dispersé dans la résine époxy cristalline, **caractérisé en ce que** ladite résine époxy est choisie parmi des éthers diglycidyliques de bisphénol A et de bisphénol F et leurs dérivés halogénés comme cela est représenté par la formule générale : 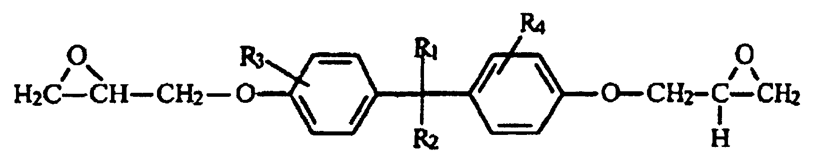
où
R¹ est un hydrogène, un halogène ou un groupe hydrocarboné ayant de un à six atomes de carbone, ou peut faire partie d'un cycle avec R² ;
R² est un hydrogène, un halogène ou un groupe hydrocarboné ayant de un à six atomes de carbone, ou peut faire partie d'un cycle avec R¹ ;
R³ est un hydrogène, un halogène ou un groupe hydrocarboné ayant de un à six atomes de carbone ;
et
R⁴ est un hydrogène, un halogène ou un groupe hydrocarboné ayant de un à six atomes de carbone.

2. Assemblage selon la revendication 1, dans lequel la bande fibreuse est au moins partiellement imprégnée par la composition de la résine matrice.

3. Assemblage selon la revendication 1, dans lequel la composition de la résine matrice forme une couche qui est en contact avec la bande fibreuse.

4. Assemblage selon la revendication 1, dans lequel la composition de la résine matrice a des propriétés adhésives.

5. Assemblage selon l'une quelconque des revendications précédentes, dans lequel la composition est durcissable dans la gamme de température de 50 °C à 200 °C.

6. Assemblage selon la revendication 5, dans lequel la composition est durcissable dans la gamme de température de 50°C à 70 °C.

7. Assemblage selon l'une quelconque des revendications précédentes, dans lequel la bande fibreuse comprend une fibre organique.

8. Assemblage selon l'une quelconque des revendications précédentes, dans lequel la bande fibreuse comprend une fibre inorganique.

9. Assemblage selon l'une quelconque des revendications précédentes, dans lequel la bande fibreuse est fournie sous forme de fibres unidirectionnelles, de tissu non tissé, de tissu croisé à plusieurs épaisseurs, ou sous forme de l'une quelconque des combinaisons de ceux-ci.

10. Assemblage selon l'une quelconque des revendications précédentes, dans lequel la composition de la résine matrice est chargée sur la bande fibreuse en des quantités dans la gamme de 30 à 3000 gm⁻².

11. Assemblage selon l'une quelconque des revendications précédentes, dans lequel l'agent de durcissement de l'époxy est choisi parmi l'un quelconque des éléments suivants, seul ou en combinaison : des imidazoles et leurs sels et adduits, des amines aromatiques, des amines aliphatiques, des anhydrides et des phénols.

12. Assemblage selon l'une quelconque des revendications précédentes, dans lequel la composition contient au moins un agent plastifiant.

13. Assemblage selon la revendication 12, dans lequel l'agent plastifiant est choisi parmi de l'un quelconque des éléments suivants, seul ou en combinaison : des caoutchoucs liquides, des résines époxy-novolaques, des monomères acrylates, des monomères méthacrylates et des esters vinyliques.

14. Assemblage selon la revendication 12 ou la revendication 13, dans lequel l'agent plastifiant constitue de 1 % à 10 % en poids de la composition.

15. Assemblage selon l'une quelconque des revendications précédentes, dans lequel la composition comprend au moins un agent adhésif non-époxy.

16. Assemblage selon la revendication 15, dans lequel l'agent adhésif est un adhésif sensible à la pression choisi parmi l'un quelconque des éléments suivants, seul ou en combinaison : des polyuréthanes, des acrylates et un caoutchouc naturel.

17. Assemblage selon l'une quelconque des revendications précédentes, dans lequel la composition comprend une ou plusieurs charges inorganiques.

18. Assemblage selon la revendication 17, dans lequel la charge inorganique est choisie parmi l'un quelconque des éléments suivants, seul ou en combinaison : la silice, l'alumine, la poudre d'aluminium, le dioxyde de titane, l'hydroxyde d'aluminium et le talc.

19. Assemblage selon l'une quelconque des revendications précédentes, dans lequel la composition comprend une maille conductrice électriquement.

20. Procédé de réalisation d'assemblage consistant essentiellement à mélanger uniformément un agent de durcissement de résine époxy cristalline avec une résine époxy cristalline pour former une résine matrice, ladite résine époxy étant choisie parmi les éthers diglycidyliques de bisphénol A et de bisphénol F et leurs dérivés halogénés, comme cela est représenté par la formule générale : 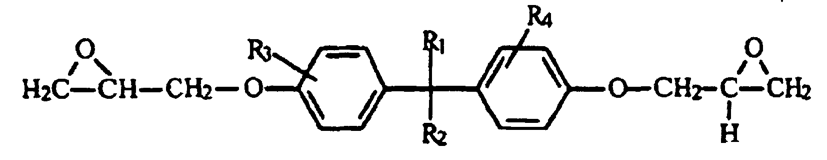
où
R¹ est un hydrogène, un halogène ou un groupe hydrocarboné ayant de un à six atomes de carbone, ou peut faire partie d'un cycle avec R² ;
R² est un hydrogène, un halogène ou un groupe hydrocarboné ayant de un à six atomes de carbone, ou peut faire partie d'un cycle avec R¹ ;
R³ est un hydrogène, un halogène ou un groupe hydrocarboné ayant de un à six atomes de carbone ;
et
R⁴ est un hydrogène, un halogène ou un groupe hydrocarboné ayant de un à six atomes de carbone,
fondant la matrice de résine résultante, appliquant la résultante matrice de résine à une bande fibreuse et à recristallisant matrice de résine fondue.
